# EUROPÄISCHE PATENTSCHRIFT

(11) **EP 3 048 866 B1**
(45) Veröffentlichungstag und Bekanntmachung des Hinweises auf die Patenterteilung: **01.11.2017**
(21) Anmeldenummer: 15151821.4
(22) Anmeldetag: 20.01.2015
(51) Int. Cl.: H05K 5/00

(54) **Gehäuse für ein elektronisches Gerät und elektronisches Gerät**
Housing for an electronic device and electronic device
Boîtier pour un appareil électrique et appareil électronique

(43) Veröffentlichungstag der Anmeldung: 27.07.2016
(73) Patentinhaber: Siemens Aktiengesellschaft, 80333 München (DE)
(72) Erfinder: Daubenmerkl, Christian, 92256 Hahnbach (DE); Schlichting, Heinrich, 93173 Wenzenbach (DE); Webermann, Gerd, 91074 Herzogenaurach (DE)

(56) Entgegenhaltungen:
- DE-A1-102006 006 386
- DE-U1-202012 100 272
- US-A1- 2004 248 619
- US-A1- 2013 032 371

## Beschreibung

Die Erfindung betrifft ein Gehäuse für ein elektronisches Gerät, umfassend einen doppelwandig ausgestalteten Rahmen, wobei der Rahmen im Wesentlichen eine erste Wand und eine zweite Wand aufweist, die erste Wand bildet dabei eine Außenwand.

Elektronische Geräte, insbesondere mobile Geräte, z.B. mobile Bedienpanels für die Industrieautomatisierung oder Handys, die vom Bediener in der Hand gehalten werden, müssen bestimmte Anforderungen bezüglich ihrer Falltauglichkeit erfüllen. So darf, nach dem das Gerät aus einer gewissen Höhe fallen gelassen wurde und auf den Boden aufschlägt, keine Gerätefunktion beeinträchtigt werden. Diese Gerätefunktionen umfassen z.B., dass das Gerät danach noch ohne Einschränkungen funktioniert und dass das Gehäuse keine Brüche aufweist. Aus dem Handbuch SIMATIC HMI, Bediengerät Mobile Panel 277 (WinCC flexible) Betriebsanleitung, 08/2008, A5E00355982-02 ist ein elektronisches Gerät, insbesondere ein mobiles Panel bekannt, bei welchem ein Fallschutz des Gerätes durch ein Doppelwand-prinzip gewährleistet ist. Dabei ist der Rahmen aus zwei Wänden (einer Geräteaußenwand und einer Geräteinnenwand), welche sich in einem gewissen Abstand zueinander befinden, aufgebaut. Die Geräteaußenwand nimmt bei einem Aufschlag auf den Boden durch Verformung die Fallenergie auf. Die Innenwand wird somit nicht beeinträchtigt und die Gerätefunktionen bleiben erhalten.

Aus der DE 199 52 641 A1 ist eine Schutzhülle mit stoßabsorbierender Füllung, insbesondere für tragbare elektronische Geräte, bekannt.

Aus der WO 03/088011 A2 ist eine mobile Recheneinheit sowie eine Erweiterungsvorrichtung für industrielle Maschinensteuerungen bekannt, wobei ein rahmen- oder gehäuseartiger Tragkörper als ein weichelastischer oder stoßdämpfender Holster ausgebildet ist.

Das Gebrauchsmuster DE 20 2012 100 272 U1 zeigt ein tragbares Bedienpanel mit einem doppelwandigen Gehäuse.

Es ist Aufgabe der Erfindung die aus dem Stand der Technik bekannten Holster, Schutzhüllen oder Rahmen nach dem Doppelwand-Prinzip zu verbessern.

Bei einem Gehäuse für ein elektronisches Gerät, umfassend einen doppelwandig ausgestalteten Rahmen, wobei der Rahmen im Wesentlichen eine erste Wand und eine zweite Wand aufweist, die erste Wand bildet dabei eine Außenwand, wird die Aufgabe dadurch gelöst, dass die erste Wand zweigeteilt ausgestaltet ist, wobei ein erster Wandteil der ersten Wand und ein zweiter Wandteil der ersten Wand derart zueinander angeordnet sind, dass bei einer von außen auf den Rahmen wirkenden Kraft der erste Wandteil unter Überwindung einer Reibkraft, welche zwischen den beiden Wandteilen herrscht, über den zweiten Wandteil verschiebbar ist.

Bei dieser Erfindung handelt es sich um eine Weiterentwicklung des beschriebenen Doppelwandprinzips. Erfindungsgemäß wird nun aber die Fallenergie nicht nur durch Verformung der Geräteaußenwand aufgenommen sondern auch durch eine entstehende Reibungsenergie, welche entsteht, wenn der erste Wandteil und der zweite Wandteil der Außenwand bei einer Verformung übereinander gleiten. Durch die Ausgestaltung der Außenwand in zwei Teilwände, welche in einen gewissen Bereich überlappend angeordnet sind, so dass sie bei einer Verformung unter Überwindung einer Reibkraft übereinander gleiten können, ergeben sich folgende Vorteile bzw. technische Effekte:

Ein Abstand zwischen der ersten Wand und der zweiten Wand (Geräteaußen- und Geräteinnenwand) kann, bei gleicher Energieaufnahme, reduziert werden. Dies hat zur Folge, dass das Gehäuse bzw. das in dem Gehäuse befindliche elektronische Geräte kleiner ausgestaltet werden kann und somit zusätzlich ein Gerätegewicht reduziert werden kann. Vor allem das Gerätegewicht spielt bei mobilen Geräten eine große Rolle hinsichtlich einer leichten Bedienbarkeit. Weiterhin kann bei gleichem Abstand zwischen den beiden Wänden (Geräteaußen- und Innenwand) eine höhere Energieaufnahme zugelassen werden. Dies hat zur Folge, dass die zugelassene maximale Fallhöhe erhöht werden kann.

Bei dem nach dem Stand der Technik bekannten Gehäusen bzw. Geräten mit dem herkömmlichen Doppelwand-Prinzip ist es weiterhin von Nachteil, dass es durch Verzug von beispielsweise einer Geräteober- und einer Geräteunterschale dazu kommen kann, dass sich zwischen den beiden Schalen ein Spalt bildet. Da das Gerät in der Hand gehalten wird, kann sich dieser gebildete Spalt für einen Benutzer in der Hand unangenehm bemerkbar machen. Weiterhin ist es dabei von Nachteil, dass sich in diesem Spalt Schmutz sammeln kann. Auch ist es nachteilig, wenn durch diesen bestehenden Spalt Wasser in den Zwischenraum zwischen der ersten Wand und der zweiten Wand eintreten kann. Da nun aber die Außenwand, also die erste Wand derart ausgebildet ist, dass bei einem zweigeteilten Rahmen, beispielsweise eine Ober- und eine Unterschale nicht bündig aufeinanderliegen, sondern die Oberschale die Unterschale überlappt, ist kein Spalt mehr vorhanden.

In einer bevorzugten Ausgestaltung sind der erste Wandteil der ersten Wand und der zweite Wandteil der ersten Wand in einem stumpfen Winkel zueinander angeordnet. Durch die Wahl des Winkels von größer 90°C bis kleiner 180°C kann die Reibkraft zwischen den beiden Wandteilen eingestellt werden.

Für einen Einbau des elektrischen Gerätes in das Gehäuse ist es von Vorteil, wenn der Rahmen einen Oberteil und einen Unterteil aufweist, welche zu einen ganzen zusammensetzbar ausgestaltet sind.

Im Hinblick auf eine erhöhte Anforderung an einen Spritzwasserschutz oder an eine Dichtheit bei zeitweiligem Untertauchen (IP 65) ist vorzugsweise zwischen dem Oberteil und dem Unterteil ein Zwischenelement derart angeordnet, dass es zwischen einem ersten Wandteil der zweiten Wand und einem zweiten Wandteil der zweiten Wand liegt. Das Zwischenelement übernimmt dabei zum einen eine Dichtfunktion und zum anderen eine stabilisierende Funktion für die auch zwei geteilte zweite Wand bzw. die Innenwand.

Im Hinblick auf die Stabilisierung der zweiten Wand ist das Zwischenelement derart ausgestaltet, dass es einen ersten Montagerahmen und einen zweiten Montagerahmen, welche parallel zueinander verlaufen, und einen Hilfsrahmen aufweist. Die beiden parallel verlaufenden Montagerahmen bilden eine Nut mit einer Dichtfläche.

In einer weiterführenden Ausgestaltung des Gehäuses weist der Rahmen eine Ausnehmung für ein Bedienelement auf und um das Bedienelement ist ein Schutzkragen angeordnet. Ist das Bedienelement beispielsweise ein NOT-AUS-Schalter und würde im Fall eines Herunterfallens des Gerätes das Gerät auf das Bedienelement NOT-AUS-Schalter fallen, so verhindert der Schutzkragen eine ungewollte Beschädigung des NOT-AUS-Schalters.

Vorteilhafter Weise ist das Gehäuse aus schlagfestem Kunststoff gefertigt.

Die eingangs genannte Aufgabe bzw. Anforderung hinsichtlich einer Minimierung des Gerätegewichtes oder einer Maximierung einer zulässigen Fallhöhe, wird durch ein elektronisches Gerät mit einem Gehäuse nach einem der Ansprüche 1 bis 7 ebenso gelöst.

Vorzugsweise ist das elektronische Gerät ausgestaltet als eine tragbare, gegen Schlag und Stoß geschützte, Bedieneinheit.

Die Zeichnung zeigt ein Ausführungsbeispiel eines Gehäuses mit einem elektronischen Gerät. Dabei zeigt die
- FIG 1: das elektronische Gerät in einer perspektivischen Darstellung,
- FIG 2: das elektronische Gerät in einer Schnittdarstellung,
- FIG 3: einen Oberteil des Gehäuses bzw. eine Oberschale,
- FIG 4: einen Unterteil des Gehäuses bzw. eine Unterschale,
- FIG 5: ein Zwischenelement und
- FIG 6: eine Prinzipdarstellung der Wirkweise des verbesserten Doppelwand-Prinzips.

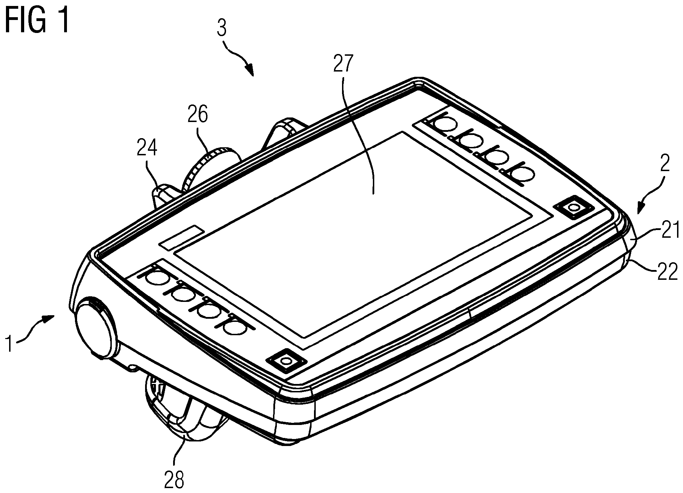

Gemäß FIG 1 ist ein industrielles Bediengerät, ausgestaltet als ein Mobil Panel mit einem Touch Screen 27 perspektivisch dargestellt. Demnach weist das Mobil Panel als elektronisches Gerät 3 ein Gehäuse 1 mit einem Rahmen 2 auf. Der Rahmen 2 weist wiederum einen Oberteil 21 und einen Unterteil 22 auf, welche zu einem Ganzen zusammensetzbar ausgestaltet sind. Um das mobile Panel sicher in der Hand zu halten, weist das mobile Panel an der Unterseite einen Traggriff 28 auf. In einer Stirnseite des mobilen Panels ist ein Bedienelement 26 ausgestaltet als NOT-AUS-Schalter angeordnet. Damit der NOT-AUS-Schalter nicht ungewollt auslöst, wenn das Gerät 3 beispielsweise zu Boden fällt, ist um den NOT-AUS-Schalter ein Schutzkragen 24 angeordnet.

Da ein mobiles Panel, insbesondere für die industrielle Automatisierungstechnik, erhöhten Umweltanforderungen ausgesetzt ist, ist das mobile Panel ausgestaltet als ein tragbares, gegen Schlag und Stoß geschütztes Bediengerät.

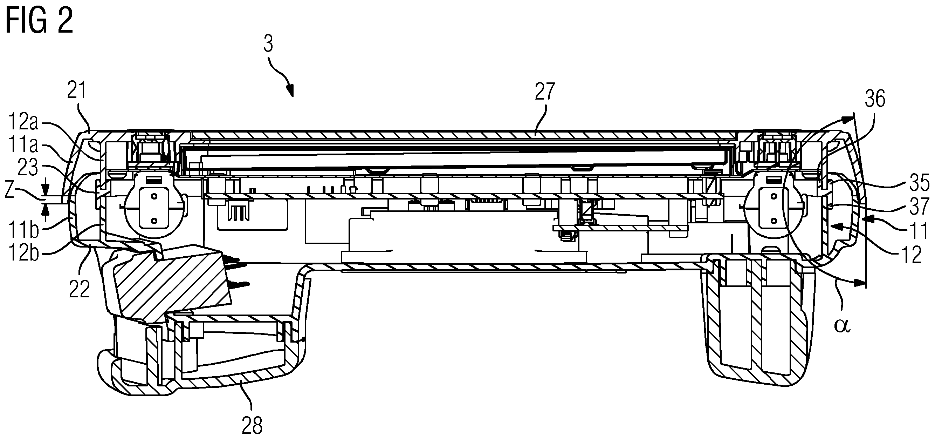

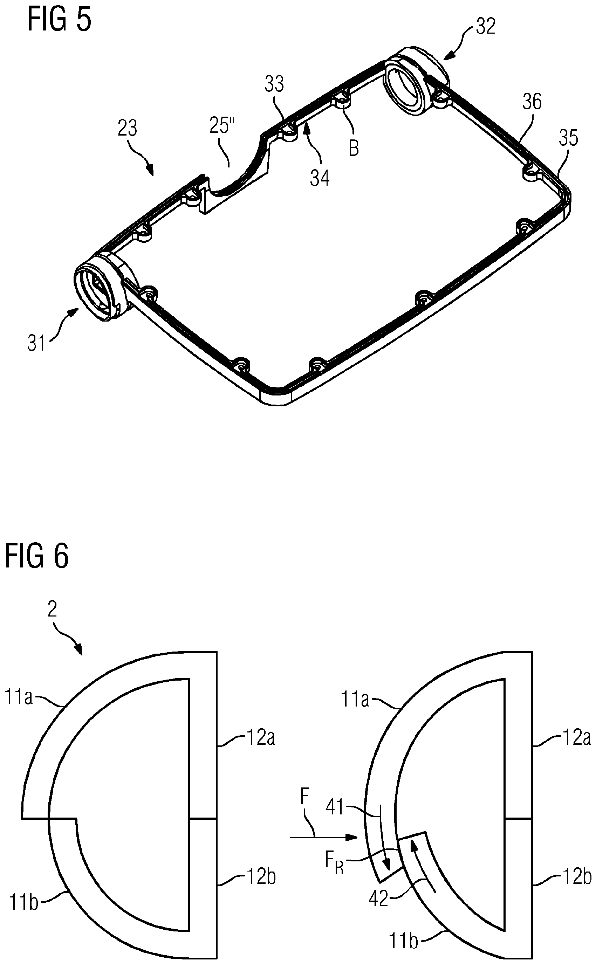

Die FIG 2 zeigt eine Schnittdarstellung des elektronischen Gerätes 3 aus FIG 1. Der Rahmen 2 des Gehäuses 1 ist als ein doppelwandig um das ganze Gerät 3 umlaufender Rahmen 2 ausgestaltet. Dabei weist der Rahmen 2 im Wesentlichen eine erste Wand 11 und eine zweite Wand 12 auf, die erste Wand 11 bildet dabei eine Außenwand. Die erste Wand 11 ist zweigeteilt ausgestaltet, wobei ein erster Wandteil 11a der ersten Wand 11 und ein zweiter Wandteil 11b der ersten Wand 11 derart zueinander angeordnet sind, dass bei einer von außen auf dem Rahmen 2 wirkenden Kraft F, der erste Wandteil 11a unter Überwindung einer Reibkraft F_{R}, welche zwischen den beiden Wandteilen 11a,11b herrscht, über den zweiten Wandteil 11b verschiebbar ist (siehe auch FIG 6). Der erste Wandteil 11a ist Bestandteil eines Oberteiles 21 und der zweite Wandteil 11b ist Bestandteil eines Unterteiles 22.

Damit eine auf den Rahmen 2 wirkende Stoßbelastung möglichst gut aufgenommen werden kann, sind der erste Wandteil 11a der ersten Wand 11 und der zweite Wandteil 11b der ersten Wand 11 in einem stumpfen Winkel α zueinander angeordnet.

Die erste Wand 11 mit ihren überlappenden Wandteilen 11a,11b bildet das verbesserte Doppelwand-Prinzip. Da auch die zweite Wand in einen ersten Wandteil 12a der zweiten Wand 12 und in einen zweiten Wandteil 12b der zweiten Wand 12 geteilt ist, ist zwischen dem ersten Wandteil 12a der zweiten Wand 12 und dem zweiten Wandteil 12b der zweiten Wand 12 ein Zwischenelement 23 angeordnet.

Das Zwischenelement 23 weist eine n-Form auf, wobei ein erster Montagerahmen 36 verläuft wodurch eine erste Nut 33 gebildet ist. Siehe auch FIG 5. In der ersten Nut 33 ist der erste Wandteil 12a der zweiten Wand 12 angeordnet und in der zweiten Nut ist der zweite Wandteil 12b der zweiten Wand 12 angeordnet. Damit übernimmt das Zwischenelement 23 die Funktion einer Dichtung. In der ersten Nut 33 wird eine Dichtfläche gebildet, die auf das erste Wandteil 12a drückt und dichtet. Ein Hilfsrahmen 37 bildet eine zweite Nut 34 mit einer weiteren Dichtfläche, auf die der zweite Wandteil 12b der zweiten Wand drückt und dichtet.

Da sich der erste Wandteil 11a der ersten Wand 11 und der zweite Wandteil 11b der ersten Wand 11 in einer Überlappungszone Z überlappen, ist auch schon die erste Wand 11 mit einer gewissen Dichtfunktionalität ausgestaltet.

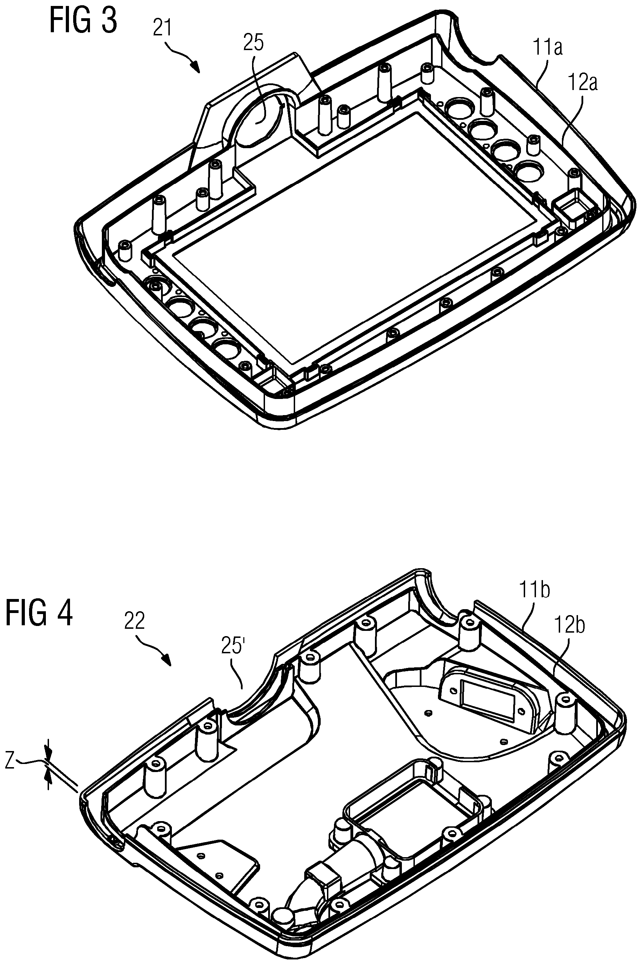

Die FIG 3 zeigt den Oberteil 21 des Gehäuses 1 in einer perspektivischen Darstellung.

Die FIG 4 zeigt den zu dem Oberteil 21 zugehörigen Unterteil 22 des Gehäuses 1 ebenfalls in einer perspektivischen Darstellung. Werden der Oberteil 21 und der Unterteil 22 zusammengefügt, so überlappt der erste Wandteil 11a der ersten Wand 11 die Überlappungszone Z des zweiten Wandteils 11b der ersten Wand 11 des Unterteils 23.

Für die Aufnahme eines Bedienelementes 26, insbesondere für die Aufnahme eines NOT-AUS-Schalters weist der Oberteil 21 eine Ausnehmung 25 auf. Der Unterteil 22 hat eine entsprechend angepasste weitere Ausnehmung 25'.

Mit der FIG 5 ist ebenfalls perspektivisch das Zwischenelement 23 dargestellt. In einer Anpassung an die Ausnehmung 25 weist das Zwischenelement 23 ebenfalls eine bogenförmige angepasste Ausnehmung 25" auf. Das Zwischenelement 23 ist als eine Art Dichtungsrahmen ausgestaltet, wobei in einer ersten Nut 33 der erste Wandteil 12a der zweiten Wand 12 angeordnet wird und in einer zweiten Nut 34 der zweite Wandteil 12b der zweiten Wand 12 angeordnet wird. Für ein Einbringen von möglichen Schnittstellen in das elektronische Gerät 3 weist das Zwischenelement 23 einen ersten Zugang 31 und einen zweiten Zugang 32 auf. Die Zugänge 31,32 sind als ein Tunnel ausgestaltet, wodurch z.B. im elektronischen Gerät ein USB-Anschluss oder eine andersartige Schnittstelle erreicht werden kann. Der erste Zugang 31 kann mit einer Dichtkappe wasserdicht verschlossen werden.

Gemäß FIG 6 wird anhand einer zweiteiligen Prinzipdarstellung die Wirkweise des verbesserten Doppelwand-Prinzips unter Ausnutzung einer entstehenden Reibkraft F_{R} gezeigt. Die linke Abbildung zeigt den prinzipiellen Schnitt durch den Rahmen 2 mit dem ersten Wandteil 11a der ersten Wand 11 und dem zweiten Wandteil 11b der ersten Wand 11 in einer Grundstellung bzw. in einer Ruhestelllung.

Die rechte Darstellung zeigt eine Stellung bei einem Aufprall des Rahmens 2, beispielsweise auf den Boden. Dadurch, dass die Kraft F auf den ersten Wandteil 11a der ersten Wand 11 einwirkt, führt der erste Wandteil 11a eine Relativbewegung 41 aus, wodurch der erste Wandteil 11a und der zweite Wandteil 11b übereinander gleiten. Zwischen den beiden Wandteilen 11a und 11b herrscht eine Reibkraft F_{R}. Dementsprechend reiben die beiden Außenwände 11a,11b aneinander und durch die Überwindung der Reibkraft F_{R} kann eine zusätzliche Energie aufgenommen werden.

## Patentansprüche

1. Gehäuse (1) für ein elektronisches Gerät (3), umfassend einen doppelwandig ausgestalteten Rahmen (2), wobei der Rahmen (2) im Wesentlichen eine erste Wand (11) und eine zweite Wand (12) aufweist, die erste Wand (11) bildet dabei eine Außenwand, wobei die erste Wand (11) zweigeteilt ausgestaltet ist, **dadurch gekennzeichnet, dass** ein erster Wandteil (11a) der ersten Wand (11) und ein zweiter Wandteil (11b) der ersten Wand (11) derart zueinander angeordnet sind, dass bei einer von außen auf den Rahmen (2) wirkenden Kraft (F) der erste Wandteil (11a) unter Überwindung einer Reibkraft (F_{R}), welche zwischen den beiden Wandteilen (11a,11b) herrscht, über den zweiten Wandteil (11b) verschiebbar ist.

2. Gehäuse (1) nach Anspruch 1, wobei der erste Wandteil (11a) der ersten Wand (11) und der zweite Wandteil (11b) der ersten Wand (11) in einem stumpfen Winkel (α) zueinander angeordnet sind.

3. Gehäuse (1) nach Anspruch 1 oder 2, wobei der Rahmen (2) einen Oberteil (21) und einen Unterteil (22) aufweist, welche zu einem Ganzen zusammensetzbar ausgestaltet sind.

4. Gehäuse (1) nach Anspruch 3, wobei zwischen dem Oberteil (21) und dem Unterteil (22) ein Zwischenelement (23) derart angeordnet ist, dass es zwischen einem ersten Wandteil (12a) der zweiten Wand (12) und einem zweiten Wandteil (12b) der zweiten Wand (12) liegt.

5. Gehäuse (1) nach Anspruch 4, wobei das Zwischenelement einen ersten Montagerahmen (35) und einen zweiten Montagerahmen (36), welche parallel zueinander verlaufen, und einen Hilfsrahmen (37) aufweist.

6. Gehäuse (1) nach einem der Ansprüche 1 bis 5, wobei der Rahmen (2) eine Ausnehmung (25) für ein Bedienelement (26) aufweist und um das Bedienelement (26) ein Schutzkragen (24) angeordnet ist.

7. Gehäuse (1) nach einem der Ansprüche 1 bis 6 aus schlagfestem Kunststoff.

8. Elektronisches Gerät (3) mit einem Gehäuse (1) nach einem der Ansprüche 1 bis 7.

9. Elektronisches Gerät (3) nach Anspruch 8, ausgestaltet als eine tragbare, gegen Schlag und Stoß geschützte Bedieneinheit.

## Claims

1. Housing (1) for an electronic device (3), comprising a double-walled frame (2), wherein the frame (2) substantially has a first wall (11) and a second wall (12), the first wall (11) here forming an outer wall, wherein the first wall (11) is embodied in two parts, **characterised in that** a first wall part (11a) of the first wall (11) and a second wall part (11b) of the first wall (11) are arranged relative to one another such that with a force (F) acting on the frame (2) from the outside, the first wall part (11a) can be shifted over the second wall part (11b) by overcoming a friction force (F_{R}) that is present between the two wall parts (11a, 11b).

2. Housing (1) according to claim 1, wherein the first wall part (11a) of the first wall (11) and the second wall part (11b) of the first wall (11) are arranged at an obtuse angle (α) relative to one another.

3. Housing (1) according to claim 1 or 2, wherein the frame (2) has an upper part (21) and a lower part (22), which are embodied so that they can be assembled into a single unit.

4. Housing (1) according to claim 3, wherein an intermediate element (23) is arranged between the upper part (21) and the lower part (22) such that it is disposed between a first wall part (12a) of the second wall (12) and a second wall part (12b) of the second wall (12).

5. Housing (1) according to claim 4, wherein the intermediate element has a first assembly frame (35) and a second assembly frame (36), which extend in parallel to one another, and an auxiliary frame (37).

6. Housing (1) according to one of claims 1 to 5, wherein the frame (2) has a recess (25) for a control element (26) and a protective collar (24) is arranged around the control element (26).

7. Housing (1) according to one of claims 1 to 6, made from impact-resistant plastic.

8. Electronic device (3) having a housing (1) according to one of claims 1 to 7.

9. Electronic device (3) according to claim 8, embodied as a portable control unit which is protected against impact and shock.

## Revendications

1. Boîtier (1) pour un appareil (3) électronique, comprenant un cadre (2) conformé à double paroi, le cadre (2) ayant essentiellement une première paroi (11) et une deuxième paroi (12), la première paroi (11) formant une paroi extérieure, la première paroi (11) étant conformée en étant divisée en deux parties, **caractérisé**
**en ce qu'**une première partie (11a) de la première paroi (11) et une deuxième partie (11b) de la première paroi (11) sont disposées l'une par rapport à l'autre, de manière à ce que, si une force (F) s'applique de l'extérieur au cadre (2), la première partie (11a) de paroi peut être déplacée sur la deuxième partie (11b) de paroi, en surmontant une force (F_{R}) de frottement, qui règne entre les deux parties (11a, 11b) de paroi.

2. Boîtier (1) suivant la revendication 1, dans lequel la première partie (11a) de la première paroi (11) et la deuxième partie (11b) de la première paroi (11) font entre elles un angle (α) obtus.

3. Boîtier (1) suivant la revendication 1 ou 2, dans lequel le cadre (2) a une partie (21) supérieure et une partie (22) inférieure, qui sont conformées de manière à pouvoir être assemblées en un tout.

4. Boîtier (1) suivant la revendication 3, dans lequel un élément (23) intermédiaire est disposé entre la partie (21) supérieure et la partie (22) inférieure, de manière à se trouver entre une première partie (12a) de la deuxième paroi (12) et une deuxième partie (12b) de la deuxième paroi (12).

5. Boîtier (1) suivant la revendication 4, dans lequel l'élément intermédiaire a un premier cadre (35) de montage et un deuxième cadre (36) de montage, qui s'étendent parallèlement l'un à l'autre, et un cadre (37) auxiliaire.

6. Boîtier (1) suivant l'une des revendications 1 à 5, dans lequel le cadre (2) a un évidement (25) pour un élément (26) de commande et un collet (24) de protection est disposé autour de l'élément (26) de commande.

7. Boîtier (1) suivant l'une des revendications 1 à 6, en matière plastique résistant aux chocs.

8. Appareil (3) électronique, comprenant un boîtier (1) suivant l'une des revendications 1 à 7.

9. Appareil (3) électronique suivant la revendication 8, conformé en unité de commande portative et protégée des chocs et des coups.
